Europäisches Patentamt

European Patent Office

Office européen des brevets

(19)

(11) Veröffentlichungsnummer: **0 168 528**
**B1**

(12)

# EUROPÄISCHE PATENTSCHRIFT

(45) Veröffentlichungstag der Patentschrift:
06.03.89

(21) Anmeldenummer: 84114899.2

(22) Anmeldetag: 07.12.84

(51) Int. Cl.⁴: **H 01 L 27/10, H 01 L 21/82**

(54) Ein-Transistor-Speicherzelle für hochintegrierte dynamische Halbleiterspeicher und Verfahren zu ihrer Herstellung.

(30) Priorität: 25.04.84 DE 3415455

(43) Veröffentlichungstag der Anmeldung:
22.01.86 Patentblatt 86/4

(45) Bekanntmachung des Hinweises auf die Patenterteilung:
06.03.89 Patentblatt 89/10

(84) Benannte Vertragsstaaten:
AT DE FR GB IT NL

(56) Entgegenhaltungen:
EP-A-0 025 325

INTERNATIONAL ELECTRON DEVICES MEETING,
TECHNICAL DIGEST, 13.-15. Dezember 1982, San
Francisco, Seiten 803-805, IEEE, New York, US; R.D.
JOLLY et al.: "A new dynamic RAM cell in
recrystallized polysilicon"
IDEM
PATENTS ABSTRACTS OF JAPAN, Band 8, Nr. 103
(E-244) 1540 , 15. Mai 1984; & JP - A - 59 19 366
(HITACHI SEISAKUSHO K.K.) 31-01-1984
IDEM
PATENTS ABSTRACTS OF JAPAN, Band 8, Nr. 256
(E-280) 1693 , 22. November 1984; & JP - A - 59 129 461
(FUJITSU K.K.) 25-07-1984

(73) Patentinhaber: **Siemens Aktiengesellschaft Berlin
und München, Wittelsbacherplatz 2, D-8000
München 2 (DE)**

(72) Erfinder: **Müller, Wolfgang, Dr., Theodor- Heuss-
Strasse 12, D-8011 Putzbrunn (DE)**

### Beschreibung

Die Erfindung bezieht sich auf eine Ein-Transistor-Speicherzelle für hochintegrierte dynamische Halbleiterspeicher nach dem Oberbegriff des Patentanspruchs 1 und auf Verfahren zu ihrer Herstellung.

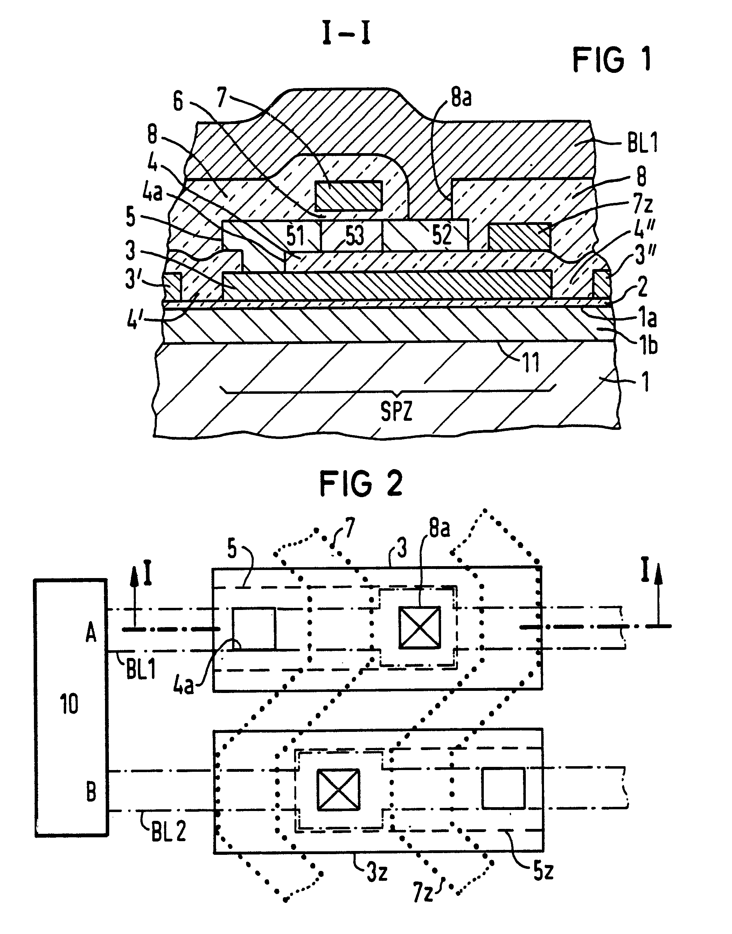

Eine Speicherzelle dieser Art ist aus IEDM 1982, Techn. Digest, Seiten 420 - 423, insbesondere Fig. 7, und Seiten 803 - 805, insbesondere Fig. 1, bekannt. Bei dieser Zelle besteht die leitende Schicht aus einer als polykristalline Halbleiterschicht aufgebrachten und sodann rekristalisierten Halbleiterschicht, wobei sowohl der über die Auswahlleitung ansteuerbare Feldeffekttransistor als auch die mit diesem verbundene erste Elektrode des Speicherkondensators aus zwei einander benachbarten Teilabschnitten dieser Schicht gebildet sind. Der von dieser Elektrode überdeckte Bereich des Halbleiterkörpers stellt eine erste Gegenelektrode des Speicherkondensators dar, während eine zweite Gegenelektrode durch eine andere leitende Schicht gebildet wird, die oberhalb der ersten Elektrode des Speicherkondensators liegt und durch eine dünne Isolationsschicht von dieser getrennt ist. Wegen des in lateraler Richtung neben dem Speicherkondensator liegenden Feldeffekttransistors ist der Flächenbedarf dieser Speicherzelle jedoch relativ groß.

Der Erfindung liegt die Aufgabe zugrunde, eine Speicherzelle der eingangs genannten Art anzugeben, die einen wesentlich kleineren Flächenbedarf hat und somit eine große Packungsdichte des Halbleiterspeichers ermöglicht. Das wird erfindungsgemäß durch eine Ausbildung der Speicherzelle nach dem kennzeichnenden Teil des Patentanspruchs 1 erreicht.

Der mit der Erfindung erzielbare Vorteil liegt insbesondere darin, daß durch die Anordnung der rekristallisierten Halbleiterschicht oberhalb der durch die leitende Schicht gebildeten Elektrode des Speicherkondensators der Flächenbedarf der Speicherzelle nur durch die Abmessungen dieser Kondensatorelektrode bestimmt ist. Damit ist aber die Flächeneffektivität der Speicherzelle, die man als das Verhältnis von der für den Speicherkondensator benötigten Halbleiterfläche zu der Halbleiterfläche der gesamten Speicherzelle definieren kann, wesentlich größer als bei den herkömmlichen Ein-Transistor-Speicherzellen.

Die Ansprüche 2 bis 10 sind auf bevorzugte Ausgestaltungen und Weiterbildungen der Erfindung gerichtet, während die Ansprüche 11 und 12 vorteilhafte Verfahren zur Herstellung der erfindungsgemäßen Speicherzelle betreffen.

Die Erfindung wird nachfolgend anhand der Zeichnung näher erläutert. Dabei zeigt:

Fig. 1　den Querschnitt einer erfindungsgemäßen Ein-Transistor-Speicherzelle,

Fig. 2　den Entwurf der Speicherzelle nach Fig. 1 und

Fig. 3　den Querschnitt einer anderen erfindungsgemäßen Ein-Transistor-Speicherzelle.

In Fig. 1 ist ein Halbleiterkörper 1 eines vorgegebenen Leitungstyps, z. B. aus p-leitendem Silizium mit einer Bor-Dotierungskonzentration von etwa $10^{15} cm^{-3}$, dargestellt, dessen Grenzfläche 1a mit einer dünnen Isolationsschicht 2, z. B. aus $SiO_2$, versenen ist. Auf dieser ist eine leitende Schicht 3 aufgebracht, die vorzugsweise aus polykristallinem Silizium besteht. Auf einer die Schicht 3 bedeckenden Zwischenisolationsschicht 4 ist eine Halbleiterschicht 5 angeordnet, die die leitende Schicht 3 über ein Kontaktfenster 4a in der Zwischenisolationsschicht 4 kontaktiert. Die Halbleiterschicht 5 besteht dabei aus einer polykristallinen Siliziumschicht, die nach dem Aufbringen z. B. durch Laserbestrahlung rekristallisiert worden ist. Sie weist $n^+$-dotierte Gebiete 51 und 52 auf, zwischen denen sich ein p-dotiertes Gebiet 53 befindet. Oberhalb des Gebiets 53 ist ein Gate 7 angeordnet, das durch eine dünne Isolationsschicht 6 von diesem getrennt ist. Auf einer Zwischenisolationsschicht 8, die die Halbleiterschicht 5 und das Gate 7 abdeckt, befindet sich eine Leiterbahn BL1, z. B. aus Aluminium, die das Gebiet 52 über ein Kontaktfenster 8a in der Schicht 8 kontaktiert.

Die Gebiete 51 und 52 stellen das Source- und Draingebiet eines N-Kanal-Feldeffekttransistors dar, dessen aus 53 bestehender Kanalbereich von dem Gate 7 überdeckt wird. Das Gate 7 ist dabei mit einer Ansteuerleitung, z. B. Wortleitung, verbunden, oder kann selbst als ein Abschnitt einer solchen Ansteuerleitung aufgefaßt werden. Die das Gebiet 52 kontaktierende Leiterbahn BL1 bildet die Daten- oder Bitleitung eines Halbleiterspeichers, während die leitende Schicht 3 die erste, mit dem Gebiet 51 verbundene Elektrode eines Speicherkondensators bedeutet, dessen Gegenelektrode aus dem unterhalb von 3 befindlichen Bereiche SPZ des Halbleiterkörpers 1 besteht. Da die Halbleiterschicht 5 in lateraler Richtung so bemessen ist, daß sie sich höchstens bis zum Rand der leitenden Schicht 3 hin erstreckt, bestimmt der Bereich SPZ nicht nur den für den Speicherkondensator erforderlichen Flächenanteil auf der Grenzfläche 1a des Halbleiterkörpers 1, sondern zugleich auch den Flächenanteil für die gesamte Ein-Transistor-Speicherzelle, die aus dem Speicherkondensator 3, 2, SPZ und dem Feldeffekttransistor 51 bis 53, 6, 7 besteht.

Der p-dotierte Halbleiterkörper 1 weist eine von seiner Grenzfläche 1a ausgehende $n^+$-dotierte Zone 1b auf, die sich etwa 0,1 bis 0,3 μm in den Halbleiterkörper hinein erstreckt. Sie ist z. B. mit Arsen dotiert, wobei die

Dotierungskonzentration etwa $10^{19}$ bis $10^{20}$cm$^{-3}$ beträgt. Dieser hohe Dotierungsgrad führt dazu, daß die durch die Oberfläche des Halbleiterbereichs SPZ gebildete Elektrode des Speicherkondensators niederohmig ist, so daß dieser schnell geladen und entladen werden kann. Der pn-Übergang 11 zwischen 1 und 1b verhindert dabei Störungen durch unerwünschte Aufladungen des Halbleiterkörpers 1, die z. B. bei Einstrahlung von Alpha-Teilchen auftreten können.

Abweichend hiervon kann der Halbleiterkörper 1 auch n-dotiert sein, wobei an seiner Grenzfläche 1b wieder die n+-dotierte Zone 1b vorgesehen ist.

Der obere Teil der Fig. 2 zeigt den Entwurf der Speicherzelle nach Fig. 1, wobei die laterale Begrenzung der leitenden Schicht 3 mit einer ausgezogenen Linie gekennzeichnet ist, während die Begrenzungen der Halbleiterschicht 5, der Leiterbahn BL1 und des Gates 7, das hierbei einen Teilabschnitt einer Ansteuerleitung bildet, jeweils als gestrichelte, strichpunktierte und punktierte Linien eingezeichnet sind. Die Kontaktfenster 4a und 8a sind durch Quadrate angedeutet, wobei das oberhalb der Schicht 5 befindliche Kontaktfenster 8a zusätzlich durch die Diagonalen des Quadrates hervorgehoben ist. Die Darstellung der Speicherzelle nach Fig. 1 entspricht einem Querschnitt längs der strichpunktierten Linie I - I von Fig. 2.

Die bisher beschriebene Ein-Transistor-Speicherzelle, deren laterale Abgrenzung durch den Rand der leitenden Schicht 3 bestimmt ist, wird nun durch eine Mehrzahl gleichartig ausgebildeter Speicherzellen, die ebenfalls auf dem Halbleiterkörper 1 integriert sind, zu einem Speicherfeld eines dynamischen Halbleiterspeichers ergänzt. Die unmittelbar benachbarten Speicherzellen sind in Fig. 1 durch leitende Schichten 3' und 3'' angedeutet, die der leitenden Schicht 3 der beschriebenen Zelle entsprechen. Die leitenden Schichten 3, 3' und 3'' sind dabei einander so weit angenähert, wie das bei der Herstellung des Speicherfeldes technologisch möglich ist, um eine große Packungsdichte der Speicherzellen zu erreichen. Eine gegenseitige Isolation ist durch die bis auf die Grenzfläche 1a reichenden Teile 4' und 4'' der Zwischenisolationsschicht 4 gegeben.

Fig. 2 läßt erkennen, wie die an einer gefalteten Bitleitung BL1, BL2 liegenden Speicherzellen eines Speicherfeldes jeweils paarweise zusammengefaßt werden können, um eine möglichst große Packungsdichte zu erzielen. Hierbei verlaufen die beiden Bitleitungshälften BL1 und BL2 ausgehend von den beiden Knoten A und B einer als Flipflop ausgebildeten Lese- und Regenerierschaltung 10 in derselben Richtung, im dargestellten Fall nach rechts. Dabei stellt die bereits beschriebene Speicherzelle 3, 5 die erste Zelle eines solchen Paares dar, während eine gleichartig aufgebaute Speicherzelle mit den lateralen Begrenzungen 3z und 5z die zweite Zelle bildet. Letztere ist gegen die erste um 180° gedreht, wobei ihre rekristalliserte Halbleiterschicht 5z gegenüber der Schicht 5 der ersten Zelle soweit in Längsrichtung der Bitleitung BL2 versetzt ist, daß die Ansteuerleitung 7 der ersten Zelle oberhalb der leitenden Schicht 3z, aber lateral neben der rekristallisierten Halbleiterschicht 5z der zweiten Zelle verläuft. In analoger Weise ist dann die Ansteuerleitung 7z der zweiten Zelle so engeordnet, daß sie oberhalb der leitenden Schicht 3, aber lateral neben der rekristallisierten Halbleiterschicht 5 der ersten Zelle verläuft. In Fig. 1 ist die Ansteuerleitung 7z der zweiten Zelle im Querschnitt dargestellt.

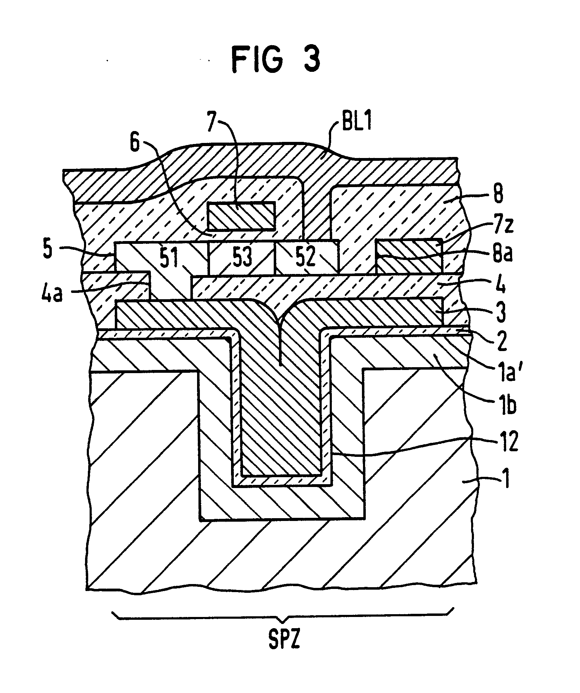

Bei der in Fig. 3 dargestellten erfindungsgemäßen Speicherzelle weist der Halbleiterkörper 1 im Bereich SPZ eine grabenförmige Ausnehmung 12 auf, wobei die Isolationsschicht 2 und die leitende Schicht 3 in ihrem Verlauf der zerklüfteten Grenzfläche 1a' des Halbleiterkörpers 1 folgen. Die übrigen Teile dieser Struktur entsprechen den mit gleichen Bezugszeichen versehenen Teilen von Fig. 1 nach Aufbau und Wirkungsweise. Durch die grabenförmige Ausnehmung 12 wird bei gleichem Halbleiterbereich SPZ die Kapazität des Speicherkondensators wesentlich erhöht oder bei gleicher Kapazität der hierfür benötigte Bereich SPZ entsprechend verkleinert. Eine solche Maßnahme ist bei herkömmlichen Speicherzellen bereits bekannt, z. B. aus IEDM 1982, Techn. Digest, Seiten 806 bis 808.

Das Gate bzw. die Ansteuerleitung 7 können nach bevorzugten Ausgestaltungen der Erfindung aus polykristallinem Silizium, aus Silizid oder aus zwei Teilschichten bestehen, die aus polykristallinem Silizium und Silizid gebildet sind. Die Ausbildung einer Ansteuerleitung aus einer solchen Doppelschicht ist an sich ebenfalls bereits bekannt, z. B. aus dem IEEE Journ. of Solid-State Circuits, SC-17, No. 5, Okt. 1982, Seiten 857 bis 861, insbesondere Fig. 4.

Schaltet man nun im Betrieb den Transistor 51 bis 53, 6, 7 durch Anlegen einer positiven Spannung an die Ansteuerleitung 7 in den leitenden Zustand, so wird eine über die Bitleitung BL1 zugeführte Informationsspannung, die einer logischen "1" oder einer logischen "0" entspricht, an die Speicherelektrode 3 gelegt, wobei sich der über einen Anschluß der Zone 1b mit seiner Gegenelektrode auf Bezugspotential gelegte Speicherkondensator entsprechend auflädt. Nach dem Sperren des Transistors durch Abschalten der positiven Spannung an der Ansteuerleitung 7 ist diese Information dann gespeichert. Beim Auslesen der gespeicherten Information wird der Transistor über das Gate 7 wieder leitend geschaltet, wobei sich das Potential der hierbei von äußeren Potentialen freigeschalteten, also im "floatenden" Zustand befindlichen Bitleitung BL1 durch die Anschaltung des informationsabhängig aufgeladenen Speicherkondensators je nach dem Ladungszustand desselben ändert. Das resultierende Potential auf der Bitleitung BL1 wird dann von der angeschlossenen Lese- und Regenerierschaltung 10 in an sich bekannter Weise ausgewertet, verstärkt und entweder ausgelesen oder während des leitenden Zustandes des Transistors 51 bis 53, 6, 7 als regeneriertes Signal wieder in die adressierte Speicherzelle eingeschrieben.

Neben der bisher beschriebenen N-Kanal-Ausführung der erfindungsgemäßen Ein-Transistor-Speicherzelle ist auch eine P-Kanal-Ausführung von Interesse, bei der die einzelnen Halbleiterteile durch solche entgegengesetzten Leitfähigkeitstyps und die zum Betrieb erforderlichen Spannungen durch solche entgegengesetzter Polarität ersetzt werden.

Bei der Herstellung einer N-Kanal-Speicherzelle 3, 5, 7 nach der Erfindung wird vorzugsweise von einem Silizium-Halbleiterkörper 1 mit einer Bor-Konzentration von $10^{15}cm^{-3}$ als Grunddotierung ausgegangen. An dessen Grenzfläche 1a wird eine n+-dotierte Halbleiterzone mit einer Eindringtiefe von 0,1 bis 0,3 µm erzeugt, die eine Arsen-Konzentration von $10^{19}$ bis $10^{20}cm^{-3}$ aufweist. Anschließend wird eine Isolationsschicht 2 aus $SiO_2$ in einer Dicke von etwa 10 nm beispielsweise durch thermische Oxidation aufgewachsen. Auf dieser wird sodann eine Schicht aus polykristallinem Silizium abgeschieden, die mit einer n+-Dotierung von etwa $10^{20}cm^{-3}$ aus Phosphor oder Arsen versehen und mittels an sich bekannter Fotolithografie- und Ätzschritte insbesondere nach einem Ionenätzverfahren in die leitende Schicht 3, die die eine Elektrode des Speicherkondensators darstellt, strukturiert wird. Es folgt das Aufbringen einer Zwischenisolationsschicht 4, beispielsweise in Form eines Oxids, das aus der Gasphase abgeschieden werden kann (CVD-Oxid). Durch einen Fotolithografie- und Ätzschritt wird dann oberhalb des Teils 3 in der Zwischenisolationsschicht 4 ein Kontaktfenster 4a vorgesehen. Auf der Schicht 4 wird anschließend eine polykristalline Siliziumschicht 5 abgeschieden und in an sich bekannter Weise durch Bestrahlung mit einem Laser- oder Elektronenstrahl rekristallisiert. Ein derartiger Rekristallisierungsvorgang ist z. B. aus IEDM 1982, Techn. Digest, Seiten 420 bis 423 und Appl. Phys. Lett., Bd. 35, 1979, Seiten 173 bis 175 bekannt. Es folgt eine Strukturierung der rekristallisierten Schicht 5 in die Gebiete 51 bis 53 mittels eines Fotografie- und Ätzschrittes. Die insoweit strukturierten Gebiete 51 bis 53 werden sodann p-dotiert, beispielsweise durch eine Implantation von Bor-Ionen.

In einem nächsten Schritt wird auf den Gebieten 51 bis 53 eine Isolationsschicht, z. B. aus $SiO_2$, mit einer Dicke von ca. 25 nm aufgewachsen, auf der dann eine Schicht aus polykristallinem Silizium oder aus einem Silizid aufgebracht und als Gate bzw. als Ansteuerleitung 7 strukturiert wird. Mit Vorteil kann diese Schicht auch aus zwei Teilschichten gebildet sein, von denen die untere aus polykristallinem Silizium und die obere aus einem Silizid besteht. Bei einer gemäß Figur 2 ausgeführten Speicherstruktur für eine gefaltete Bitleitung wird gleichzeitig mit dem Gate bzw. der Ansteuerleitung 7 der Speicherzelle 3, 5 ein weiteres Gate bzw. eine weitere Ansteuerleitung 7z vorgesehen, die das Gate bzw. die Ansteuerleitung für die benachbarte Speicherzelle 3z, 5z darstellt. Es folgt eine n+-Dotierung der Source- bzw. Draingebiete 51, 52 des Feldeffekttransistors mittels einer Implantation von Arsen-Ionen, wobei das Gate 7 als Dotierungsmaske dient. Hierbei entsteht in den Gebieten 51 und 52 eine Dotierungskonzentration von etwa $10^{17}cm^{-3}$.

Weiterhin wird eine Zwischenisolationsschicht 8 aus Oxid abgeschieden, in der auf fotolithografischem Wege ein Kontaktfenster 8a vorgesehen wird. Schließlich wird eine Leiterbahn BL1, insbesondere aus Aluminium, abgeschieden, die dann im Bereich des Kontaktfensters 8a das Gebiet 52 kontaktiert.

Für eine erfindungsgemäße Speicherzelle nach Fig. 3 wird der Halbleiterkörper 1 vor dem Erzeugen der n+-dotierten Zone 1b mit einer grabenförmigen Ausnehmung 12 versehen, was vorzugsweise durch einen Ätzschritt geschehen kann.

**Patentansprüche**

1. Ein-Transistor-Speicherzelle für hochintegrierte dynamische Halbleiterspeicher mit einem an einer Bitleitung liegenden Feldeffekttransistor, der ein über eine Auswahlleitung ansteuerbares Gate aufweist, und mit einem Speicherkondensator, bei der ein Halbleiterkörper an einer seiner Grenzflächen mit einer ersten dünnen Isolationsschicht und einer auf dieser aufgebrachten leitenden Schicht versehen ist, wobei letztere eine Elektrode des Speicherkondensators darstellt und mit dem Feldeffekttransistor verbunden ist, während der von der leitenden Schicht überdeckte Bereich des Halbleiterkörpers die andere Elektrode des Speicherkondensators bildet, und bei der der Feldeffekttransistor in einer als polykristalline Halbleiterschicht aufgebrachten und sodann rekristallisierten Halbleiterschicht realisiert ist, dadurch gekennzeichnet, daß die rekristallisierte Halbleiterschicht (5) oberhalb der leitenden Schicht (3) liegt und durch eine erste Zwischenisolationsschicht (4) von dieser getrennt ist, daß sich die rekristallisierte Halbleiterschicht (5) in lateraler Richtung höchstens bis zum Rand der leitenden Schicht (3) hin erstreckt und daß das Gate (7) des Feldeffekttransistors oberhalb der rekristallisierten Halbleiterschicht (5) liegt und durch eine zweite dünne Isolationsschicht (6) von dieser getrennt ist.

2. Ein-Transistor-Speicherzelle nach Anspruch 1, dadurch gekennzeichnet, daß der Halbleiterkörper (1) an der Grenzfläche (1a), die mit der ersten dünnen Isolationsschicht (2) versehen ist, eine Zone (1b) aufweist, die einen stärkeren Dotierungsgrad aufweist als seiner Grunddotierung entspricht.

3. Ein-Transistor-Speicherzelle nach Anspruch 1 oder 2, dadurch gekennzeichnet, daß der Halbleiterkörper (1) an der Grenzfläche (1a), die mit der ersten dünnen Isolationsschicht (2) versehen ist, eine Zone (1b) aufweist, deren Leitfähigkeit zu der des Halbleiterkörpers entgegengesetzt ist.

4. Ein-Transistor-Speicherzelle nach einem der Ansprüche 1 bis 3, dadurch gekennzeichnet, daß die Bitleitung aus einer Leiterbahn (BL1) besteht, die oberhalb des Gate (7) angeordnet und durch eine zweite Zwischenisolationsschicht (8) von diesem getrennt ist.

5. Ein-Transistor-Speicherzelle nach einem der Ansprüche 1 bis 4, dadurch gekennzeichnet, daß die erste leitende Schicht (3) aus polykristallinem Silizium besteht.

6. Ein-Transistor-Speicherzelle nach einem der Ansprüche 1 bis 5, dadurch gekennzeichnet, daß das Gate (7) aus polykristallinem Silizium besteht.

7. Ein-Transistor-Speicherzelle nach einem der Ansprüche 1 bis 5, dadurch gekennzeichnet, daß das Gate (7) aus Silizid besteht.

8. Ein-Transistor-Speicherzelle nach einem der Ansprüche 1 bis 5, dadurch gekennzeichnet, daß das Gate (7) aus zwei Teilschichten gebildet ist, die aus polykristallinem Silizium und Silizid bestehen.

9. Ein-Transistor-Speicherzelle nach einem der Ansprüche 1 bis 8, dadurch gekennzeichnet, daß der von der leitenden Schicht (3) überdeckte Bereich (SPZ) des Halbleiterkörpers (1) eine grabenartige Ausnehmung (12) aufweist.

10. Halbleiterspeicher mit einer Mehrzahl von Ein-Transistor-Speicherzellen nach einem der Ansprüche 1 bis 9, dadurch gekennzeichnet, daß die Speicherzellen jeweils paarweise nebeneinander angeordnet sind, wobei die rekristallisierten Halbleiterschichten (5, 5z) der beiden Speicherzellen eines solchen Paares in Richtung der zugehörigen, parallel zueinander verlaufenden Bitleitungen (BL1, BL2) gegeneinander versetzt angeordnet sind und daß die Auswahlleitung (7) für die eine Speicherzelle eines solchen Paares jeweils oberhalb der leitenden Schicht (3z) aber lateral neben der rekristallisierten Halbleiterschicht (5z) der jeweils anderen Speicherzelle dieses Paares angeordnet ist.

11. Verfahren zur Herstellung einer Ein-Transistorspeicherzelle nach einem der Ansprüche 1 bis 9, dadurch gekennzeichnet, daß ein Halbleiterkörper (1) aus dotiertem Halbleitermaterial, der an einer Grenzfläche (1a) eine Zone (1b) mit einem gegenüber der Grunddotierung erhöhten Dotierungsgrad aufweist, an dieser Grenzfläche (1a) mit einer ersten dünnen Isolationsschicht (2) versehen wird, daß hierauf eine Schicht aus polykristallinem Silizium abgeschieden, mit einer starken Dotierung versehen und mittels eines Fotolithografie- und Ätzschrittes in eine eine Elektrode des Speicherkondensators darstellende leitende Schicht (3) strukturiert wird, daß auf dieser eine erste Zwischenisolationsschicht (4) aufgebracht wird, in der oberhalb der leitenden Schicht (3) ein Kontaktfenster (4a) vorgesehen wird, daß auf dieser ersten Zwischenisolationsschicht (4) eine polykristalline Schicht (5) abgeschieden, durch Bestrahlung rekristallisiert, mittels eines Fotolithografie- und Ätzschrittes strukturiert und sodann mit einer Grunddotierung versehen wird, daß oberhalb der rekristallisierten Schicht (5) eine zweite dünne Isolationsschicht (6) aufgebracht wird, auf der eine Schicht aus leitendem Material aufgebracht und als Gate (7) des Feldeffekttransistors strukturiert wird, daß danach eine Dotierung der die Source- und Drain-Gebiete des Feldeffekttransistors darstellenden Teile (51, 52) der rekristallisierten Schicht (5) im Wege einer Ionenimplantation erfolgt, daß anschließend eine zweite Zwischenisolationsschicht (8) oberhalb des Gate (7) vorgesehen wird, in der oberhalb der rekristallisierten Schicht (5) ein Kontaktfenster (8a) vorgesehen wird, und daß auf der zweiten Zwischenisolationsschicht (8) eine Leiterbahn (BL1) abgeschieden wird, die die rekristallisierte Schicht (5) im Bereich des zweiten Kontaktfensters (8a) kontaktiert.

12. Verfahren nach Anspruch 11, dadurch gekennzeichnet, daß der Halbleiterkörper (1) vor der Erzeugung der Zone (1b) mit einem gegenüber der Grunddotierung erhöhten Dotierungsgred insbesondere durch Ätzung mit einer grabenförmigen Ausnehmung (12) versehen wird.

**Claims**

1. One-transistor memory cell for high-density integrated dynamic semiconductor memories, comprising a field-effect transistor which is located at a bit line and which exhibits a gate which can be enabled via a selection line, and comprising a storage capacitor, in which cell a semiconductor body is provided at one of its boundary faces with a first thin insulation layer and a conductive layer applied to the latter, the latter representing an electrode of the storage capacitor and being connected to the field-effect transistor whilst the area of the semiconductor body which is covered by the conductive layer forms the other electrode of the storage capacitor, and in which cell the field-effect transistor is implemented in a semiconductor layer which is applied as polycrystalline semiconductor layer and is then recrystallized, characterized in that the recrystallized semiconductor layer (5) is located above the conductive layer (3) and is separated from the latter by a first intermediate insulation layer (4), that the recrystallized semiconductor layer (5) extends in the lateral direction to the edge of the conductive layer (3) at the most and that the gate (7) of the field-effect transistor is located above the recrystallized semiconductor layer (5) and is separated from the latter by a second thin insulation layer (6).

2. One-transistor memory cell according to Claim 1, characterized in that the semiconductor body (1) exhibits at the boundary face (1a), which is provided with the first thin insulation layer (2), a zone (1b) which exhibits a higher degree of doping than corresponds to its basic doping.

3. One-transistor memory cell according to Claim 1 or 2, characterized in that the semiconductor body (1) exhibits at the boundary face (1a), which is provided with the first thin insulation layer (2), a zone (1b), the conductivity of which is opposite to that of the semiconductor body.

4. One-transistor memory cell according to one of Claims 1 to 3, characterized in that the bit line consists of a conductor track (BL1) which is arranged above the gate (7) and is separated from the latter by a second intermediate insulation layer (8).

5. One-transistor memory cell according to one of Claims 1 to 4, characterized in that the first conductive layer (3) consists of polycrystalline silicon.

6. One-transistor memory cell according to one of Claims 1 to 5, characterized in that the gate (7) consists of polycrystalline silicon.

7. One-transistor memory cell according to one of Claims 1 to 5, characterized in that the gate (7) consists of silicide.

8. One-transistor memory cell according to one of Claims 1 to 5, characterized in that the gate (7) is formed of two part-layers which consist of polycrystalline silicon and silicide.

9. One-transistor memory cell according to one of Claims 1 to 8, characterized in that the area (SP2) of the semiconductor body (1) which is covered by the conductive layer (3) exhibits a trough-like recess (12).

10. Semiconductor memory having a plurality of one transistor memory cells according to one of Claims 1 to 9, characterized in that the memory cells are in each case arranged in pairs next to one another, the recrystallized semiconductor layers (5, 5z) of the two memory cells of such a pair being arranged offset with respect to one another in the direction of associated bit lines (BL1, BL2) which extend in parallel to one another, and that the selection line (7) for one memory cell of such a pair is in each case arranged above the conductive layer (3z) but laterally next to the recrystallized semiconductor layer (5z) of the respective other memory cell of this pair.

11. Method for manufacturing a one-transistor memory cell according to one of Claims 1 to 9, characterized in that a semiconductor body (1) of doped semiconductor material, which exhibits at one boundary face (1a) a zone (1b) with a degree of doping which is increased compared with the basic doping, is provided at this boundary face (1a) with a first thin insulation layer (2), that a layer of polycrystalline silicon is deposited thereon, provided with a high doping and structured by means of a photolithography and etching step into a conductive layer (3) which represents one electrode of the storage capacitor, that a first intermediate insulation layer (4) is applied to the latter, in which a contact window (4a) is provided above the conductive layer (3), that a polycrystalline layer (5) is deposited on this first intermediate insulation layer (4), is recrystallized by irradiation, structured by means of a photolithography and etching step and is then provided with a basic doping, that a second thin insulation layer (6) is applied above the recrystallized layer (5), to which a layer of conductive material is applied and is structured as gate (7) of the field-effect transistor, that thereafter the parts (51, 52) of the recrystallized layer (5) which represent the source and drain areas of the field-effect transistor are doped by way of an ion implantation, that subsequently a second intermediate insulation layer (8) is provided above the gate (7), in which a contact window (8a) is provided above the recrystallized layer (5), and that a conductor track (BL1), which comes into contact with the recrystallized layer (5) in the area of the second contact window (8a), is deposited on the second intermediate insulation layer (8).

12. Method according to Claim 11, characterized in that the semiconductor body (1) is provided with a degree of doping which is increased compared with the basic doping, particularly by etching with a trough-shaped recess (12), before the zone (1b) is generated.


**Revendications**

1. Cellule de mémoire à un transistor pour des mémoires dynamiques à semiconducteurs à haute densité d'intégration, comportant un transistor à effet de champ raccordé à une ligne de transmission de bits et possédant une grille pouvant être commandée par l'intermédiaire d'une ligne de sélection, et un condensateur de stockage, et dans laquelle un corps semiconducteur comporte au niveau de l'une de ses interfaces, une première couche isolante mince et une couche conductrice déposée sur cette couche isolante, la couche conductrice représentant une électrode du condensateur de stockage et étant reliée au transistor à effet de champ, tandis que la région, recouverte par la couche conductrice, du corps semiconducteur forme l'autre électrode du condensateur de stockage, et dans laquelle le transistor à effet de champ est formé dans une couche semiconductrice déposée sous la forme d'une couche semiconductrice polycristalline et recristallisée ensuite, caractérisée par le fait que la couche semiconductrice recristallisée (5) est située au-dessus de la couche conductrice (3) et est séparée de cette dernière par une première couche isolante intercalaire (4), que la couche semiconductrices recristallisée (5) s'étend au maximum, dans la direction latérale, jusqu'au bord de la couche conductrice (3) et que la grille (7) du transistor à effet de champ est située au-dessus de la couche semiconductrice recristallisée (5) et est séparée de cette couche par une seconde couche isolante mince (6).

2. Cellule de mémoire à un transistor suivant la revendication 1, caractérisée par le fait que le corps semiconducteur (1) possède, au niveau de l'interface (1a) qui est pourvue de la première couche isolante mince (2), une zone (1b) possédant un degré de dopage supérieur à ce qui correspond à un dopage de base.

3. Cellule de mémoire à un transistor suivant la revendication 1 ou 2, caractérisée par le fait que le corps semiconducteur (1) possède, au niveau de l'interface (1a) qui est pourvue de la première couche isolante mince (2), une zone (1b), dont la conductivité est opposée celle du corps semiconducteur.

4. Cellule de mémoire à un transistor suivant l'une des revendications 1 à 3, caractérisée par le fait que la ligne de transmission de bits est constituée par une voie conductrice (BL1), qui est disposée au-dessus de la grille (7) et est séparée de cette dernière par une seconde couche isolante intercalaire (8).

5. Cellule de mémoire à un transistor suivant l'une des revendications 1 à 4, caractérisée par le fait que la première couche conductrice (3) est formée par du silicium polycristallin.

6. Cellule de mémoire à un transistor suivant l'une des revendications 1 à 5, caractérisée par le fait que la grille (7) est constituée par du silicium polycristallin.

7. Cellule de mémoire à un transistor suivant l'une des revendications 1 à 5, caractérisée par le fait que la grille (7) est constituée par du silicium.

8. Cellule de mémoire à un transistor suivant l'une des revendications 1 à 5, caractérisée par le fait que la grille (7) est formée de deux couches partielles, qui sont constituées par du silicium polycristallin et un siliciure.

9. Cellule de mémoire à un transistor suivant l'une des revendications 1 à 8, caractérisée par le fait que la zone (SPZ) du corps semiconducteur (1), recouverte par la couche conductrice (3), comporte un évidement en forme de sillon (12).

10. Mémoire à semiconducteurs comportant une multiplicité de cellules de mémoire à un transistor suivant l'une des revendications 1 à 9, caractérisée par le fait que les cellules de mémoire sont disposées respectivement par couples côte-à-côte, les couches semiconductrices recristallisées (5, 5z) des deux cellules de mémoire d'un tel couple étant disposées, en étant décalées l'une par rapport à l'autre, dans la direction des lignes associées de transmission de bits (BL1, BL2), qui sont parallèles entre elles, et que la ligne de sélection (7) pour une cellule de mémoire d'un tel couple est disposée respectivement au-dessus de la couche conductrice (3z), mais latéralement à côté de la couche semiconductrice recristallisée (5z) de l'autre cellule de mémoire respective de ce couple.

11. Procédé pour fabriquer une cellule de mémoire à un transistor suivant l'une des revendications 1 à 9, caractérisé par le fait qu'on équipe le corps semiconducteur (1) qui est formé d'un matériau semiconducteur dopé et possède, au niveau d'une interface (1a), une zone (1b) possédant un degré de dopage supérieur au dopage de base, d'une première couche isolante mince (2) au niveau de cette interface (1a), que sur cette couche on dépose une couche de silicium polycristallin, qu'on y applique un dopage intense et qu'on la structure à l'aide d'une opération de photolithographie et de corrosion, pour obtenir une couche conductrice (3) représentant une électrode du condensateur de stockage, qu'on dépose sur cette couche une première couche isolante intercalaire (4), dans laquelle on aménage une fenêtre de contact (4a) au-dessus de la couche conductrice (3), que sur cette première couche isolante intercalaire (4) on dépose une couche polycristalline (5), on la fait recristalliser au moyen d'une irradiation, on la structure au moyen d'une opération de photolithographie ou de corrosion et on y introduit ensuite un dopage de base, qu'au-dessus de la couche recristallisée (5) on dépose une seconde couche isolante (6), sur laquelle on dépose une couche réalisée en un matériau conducteur et qu'on la structure de manière à former la grille (7) du transistor à effet de champ, puis qu'on réalise un dopage des particules (51, 52) de la couche recristallisée (5), qui représentent les régions de source et de drain du transistor à effet de champ, au cours d'une implantation ionique, qu'on prévoit ensuite, au-dessus de la grille (7), une seconde couche isolante intercalaire (8), dans laquelle on aménage une fenêtre de contact (8a) au-dessus de la couche recristallisée (5), et qu'on dépose, sur la seconde couche isolante intercalaire (8), une voie conductrice (BL1), qui est en contact avec la couche recristallisée (5) dans la zone de la seconde fenêtre de contact (8a).

12. Procédé suivant la revendication 11, caractérisé par le fait qu'avant la formation de la zone (1b), on donne au corps semiconducteur (1) un degré de dopage accru par rapport au dopage de base, notamment par corrosion avec un évidement en forme de sillon (12).

I – I

FIG 1

FIG 2

# FIG 3

SPZ